# EUROPEAN PATENT APPLICATION

(11) **EP 4 303 062 A1**
(43) Date of publication of application: **10.01.2024**
(21) Application number: 22183804.8
(22) Date of filing: 08.07.2022
(51) Int. Cl.: B60L 3/00, B60L 53/10, B60L 53/14

(54) **VEHICLE CHARGING DIAGNOSTIC APPARATUS, METHOD, AND SOFTWARE**

(71) Applicant: Aptiv Technologies Limited, St. Michael (BB)
(72) Inventor: DEBSKI, Janusz, Dublin, 2 (IE); TYPROWICZ, Wojciech, Dublin, 2 (IE); TOKARZ, Krzysztof, Dublin, 2 (IE)
(74) Representative: Gaunt, Thomas Derrick

(57) **Abstract**

Vehicle charging diagnostic apparatus including a voltage sensor (11) for determining the voltage on a control pilot line (5). A diagnostic controller (10) is provided for identifying a first fault in response to detecting, using the voltage sensor (11), a negative voltage at or below a threshold, such as -15V. A current sensor (12) may be provided for sensing the current on the proximity pilot line (6), with the diagnostic controller (10) identifying a further fault in response to detecting fluctuations in the current sensed by the current sensor (12).

## Description

### Field

The present disclosure relates to a vehicle charging diagnostic apparatus, a diagnostic method for vehicle charging systems, and software for performing the same. The present disclosure is particularly relevant to Protective Earth (PE) loss detection systems, and an in-vehicle charge controller apparatus including PE loss detection.

### Background

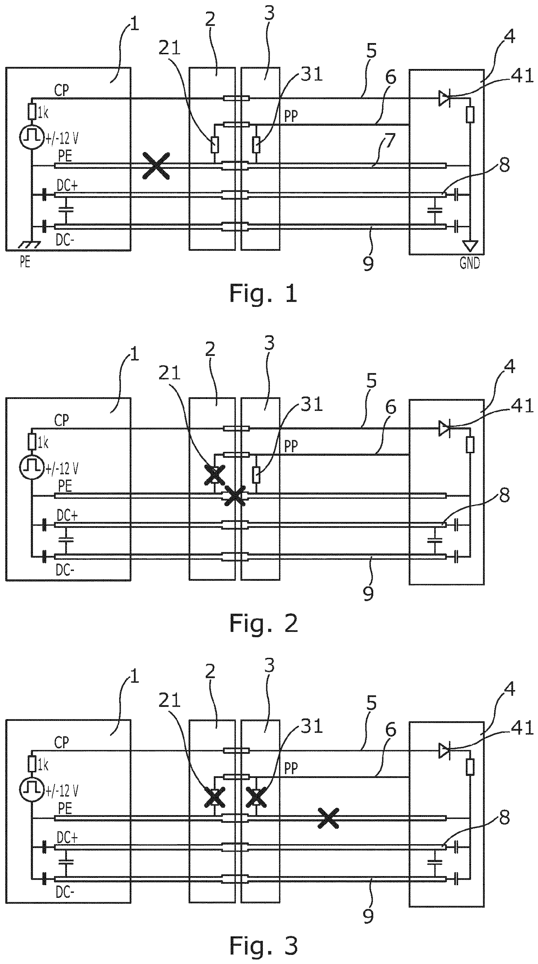

Electric vehicles (EV) are typically charged using a Combined Charging System, CCS, protocol according to IEC 61851-1 standard and above. These protocols set out specifications for both charging and the communications between the charging station and the vehicle's onboard charge controller used to manage the charging process. In this respect, Figure 1 provides a schematic overview of a conventional charging arrangement where a vehicle charging controller 4 is connected to a charging station 1 by a charging station coupler 2 being plugged into the vehicle's inlet 3. This establishes typically five conductive lines between the vehicle charging controller 4 and the charging station 1, namely a positive line (DC+) 8, negative line (DC-) 9, a protective earth (PE) 7, a proximity pilot (PP) 6, and a control pilot (CP) 5. The PP 6 is used for communicating the specification of the cable connected to the vehicle inlet or socket 3, and the CP line 5 is used to provide bidirectional communications between the charging station 1 and the vehicle charging controller 4. The CP 5 and PP 6 lines therefore allow the system to determine the maximum amount of current that can be both delivered through the connector cable and received by the vehicle charging controller 4 at any one time. Pulse-width modulation (PWM) is used to effect communication over the CP and PP lines.

The charging protocols also include various safety mechanisms, such as PE loss detection. For instance, if a charging coupler 2 is unexpectedly unplugged during charging, the CP line 5 becomes interrupted and, in response, the charging station 1 immediately stops charging. This thereby avoids arcs and high voltage exposure when the coupler 2 is detached. However, faults may occur when the charging coupler 2 remains plugged in, and hence there is no loss of the CP line 5. For example, Figure 1 shows a PE line 7 disconnection between the charging station 1 and the coupler 2. As such, to provide PE loss detection, the PE line is also monitored by the charging station.

Although such mechanisms provide effective safety protection, they often do not allow diagnostics of where the fault occurs. For example, Figures 2 and 3 show other PE line 7 faults, different to that shown in Figure 1. In these scenarios the PE loss may occur, for instance, at the connection between the coupler 2 and vehicle inlet 3, and may also be accompanied by faults in the coupler PP resistor 21 and/or the inlet PP resistor 31. For example, the coupler PP resistor 21 can form a 1.5kQ resistive connection between the PE and the vehicle ground, which can bypass PE faults occurring at or after the coupler/inlet interface. However, if a voltage difference higher than 30V is applied across the coupler PP resistor, this resistor may break down and fail. Conventional diagnostic systems are unable to differentiate this types of fault where component damage may have occurred compared to other faults. As such, it is often unclear whether a fault lies with the charging station 1, its coupler 2, or within the vehicle itself. This can make maintenance difficult, particularly for the owners of vehicles.

Accordingly, there remains a need to address the shortcomings with conventional EV charging methods and diagnostic systems.

### Summary

According to a first aspect, there is provided a vehicle charging diagnostic apparatus including: a voltage sensor for determining the voltage on a control pilot line; and a diagnostic controller for identifying a first fault in response to detecting, using the voltage sensor, a negative voltage at or below a threshold.

In this way, PE line faults may be detected at the vehicle based on monitoring the voltage on the CP line, for example across the CP line diode. That is, in the event of a PE line fault, a diode in the CP line and the y-capacitance on the DC+ and DC- lines, creates a negative charge pump circuit effect on the CP line. Accordingly, although the normal CP signal on the charging station side may be, for instance, +/-12V 1kHz relative to the PE, the negative charge pump effect causes a negative voltage drop across the CP diode to, for example, be -15 to -24V. Accordingly, PE line faults may be detected at the electric vehicle by detecting a negative signal amplitude which is larger than a predetermined threshold.

In embodiments, the threshold is between -13V to -30V. In embodiments the threshold is -15V. In this way, a negative voltage larger than the typical CP line signal may be detected and used to trigger the detection of a PE loss fault. For example, if the typical CP line signal is +/-12V, a negative voltage larger than -13 to -15 may trigger the detection of a PE loss fault.

In embodiments, the negative voltage corresponds to the charging station having a negative potential. In this way, the CP line within the electric vehicle has a positive potential relative to the charging station.

In embodiments, the diagnostic controller outputs a first fault indicator in response to identifying a first fault. In this way, an indicator is output identifying the type of PE loss fault as being associated with a negative CP line voltage.

In embodiments, the first fault indicator is associated with a permanent earth disconnection fault between one of: (i) a charging station and its coupler, (ii) the charging station and a vehicle inlet, where an inlet proximity pilot (PP) resistor is damaged, and (iii) the vehicle inlet and a vehicle charge controller, where an inlet PP resistor is damaged and a coupler PP resistor is damaged. In this way, the indicator identifies the likely location or nature of the fault causing the PE line loss. This may therefore allow for more straightforward repair operations.

In embodiments, the vehicle charging diagnostic apparatus, further including a current sensor for sensing the current on the proximity pilot (PP) line; and wherein the diagnostic controller is further configured to monitor characteristics in the current sensed by the current sensor and identifying a further fault in response to the detected characteristics. In this way, other types of PE line loss faults may be identified. In embodiments, the characteristics in the current comprise amplitude fluctuations.

In embodiments, the fluctuations in the current have a signal frequency of between 900Hz-1.1kHz. In this way, current fluctuations caused by the CP line signal flowing through a pull up resistor on the PP line may be used to identify a PE loss fault.

In embodiments, the diagnostic controller is configured to output a further fault indicator in response to identifying a further fault. In this way, further types of PE loss faults may be differentiated from first faults.

In embodiments, the diagnostic controller categorises the further fault based on a peak to trough amplitude being within a predetermined range. In this way, the amplitude of the CP line fault may be used to diagnose the type/location of the fault, which in turn may allow the fault to be fixed more easily.

In embodiments, the diagnostic controller identifies the further fault as a second fault in response to the sensed current having a peak to trough amplitude of 1mA to 3mA, wherein the second fault is one in which the permanent earth line is broken between a coupler and a vehicle inlet, where a coupler PP resistor and inlet PP resistor are undamaged, and wherein a second fault indicator is output as the further fault indicator in response to the identification of a second fault.

In embodiments, the diagnostic controller identifies the further fault as a third fault in response to the sensed current having a peak to trough amplitude of 0mA to 2mA, in which the permanent earth line is broken between a vehicle inlet and a vehicle charge controller, where a coupler PP resistor and inlet PP resistor are undamaged, and wherein a third fault indicator is output as the further fault indicator in response to the identification of a third fault. In this way, the lower amplitude signal on the CP line fault may be used to diagnose the type/location of the fault, which in turn may allow the fault to be fixed more easily.

In embodiments, the diagnostic controller is configured to stop a charging operation in response to identifying a first fault or a further fault. In this way, additional safety controls may be provided within the electric vehicle.

According to a second aspect, there is provided a vehicle charging diagnostic method comprising the steps of: determining, using a voltage sensor, the voltage on a control pilot line; and identifying, by a diagnostic controller, a first fault in response to detecting, using the voltage sensor, a negative voltage at or below a threshold. In this way, a method is provided for identifying PE line faults at the vehicle based on monitoring the voltage on the CP line.

In embodiments, the method further includes the step of: outputting, by the diagnostic controller, a first fault indicator in response to identifying a first fault.

In embodiments, the method further includes the steps of: sensing, using a current sensor, the current on the PP line; and identifying, by the diagnostic controller, characteristics in the sensed current and identifying a further fault in response to the detected characteristics .

According to a third aspect, there is provided a non-transient computer readable medium including instructions which, when executed by a processor, implements the above method.

According to a further aspect, there is provided a computer software product comprising instructions which, when executed by a processor, implements the above method.

### Brief Description of Drawings

Illustrative embodiments will now be described with reference to the accompanying drawings in which:
Figure 1 is a schematic illustration of a conventional charging arrangement where a vehicle is connected to a charging station with a PE loss fault shown between the charging station and the coupler;
Figure 2 is a schematic illustration of a conventional charging arrangement with a PE loss fault shown between the coupler and the vehicle inlet, with the coupler PP resistor damaged;
Figure 3 is a schematic illustration of a conventional charging arrangement with a PE loss fault shown between the vehicle inlet and the vehicle, with the coupler and inlet PP resistors damaged;
Figure 4 is a schematic illustration of a charging arrangement including a diagnostic apparatus according to a first illustrative embodiment; and
Figure 5 is a schematic illustration of a charging arrangement including a diagnostic apparatus according to a second illustrative embodiment.

### Detailed Description

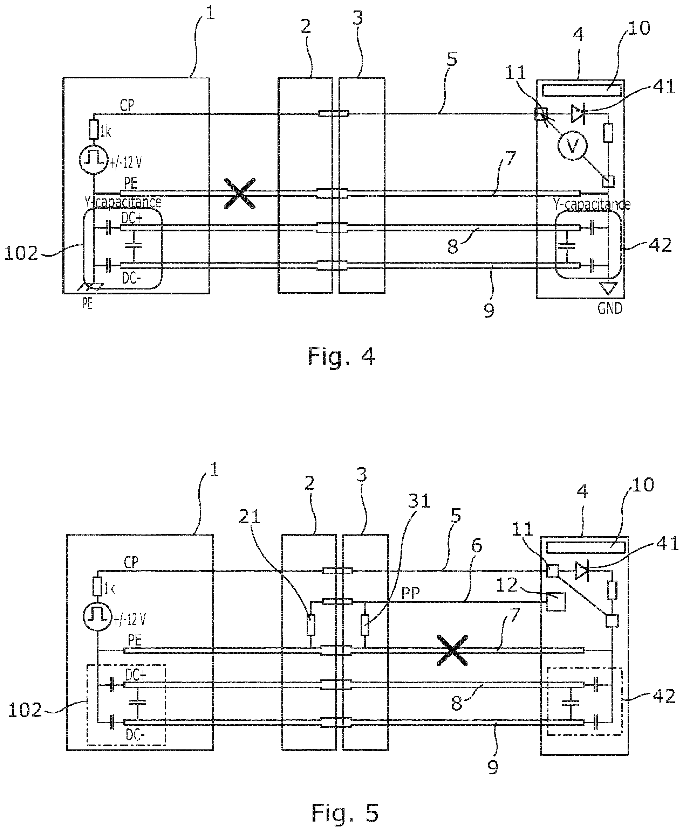

Figure 4 is a schematic illustration of a charging arrangement including a diagnostic apparatus according to a first illustrative embodiment. As shown, a diagnostic controller 10 is provided within the vehicle charging controller 4, along with a voltage sensor 11 for sensing the voltage across the CP diode 41 on the CP line 5. The diagnostic controller 10 logs sensor readings from the voltage sensor 11 and outputs fault identifiers in response to any detected faults. It will be understood that the diagnostic controller 10 may be integrated into a vehicle's charge controller processor or another electronic control unit (ECU) within the vehicle.

In this charging arrangement, the CP signal applied by the charging station is +/-12V 1kHz at a minimum 3% duty cycle, relative to the PE line 7. At the same time, it will be understood that the DC+ and DC- lines 8,9 incorporate Y-capacitor arrangements 102 and 42 in both the charging station 1 and vehicle charging controller 4 ends. The Y-capacitance of each Y-capacitor arrangement is at least InF. It will also be understood that the vehicle charging controller 4 circuit is also connected to the vehicle ground, as shown.

In the event of a first type of PE line 7 fault in which both the PE and PP line 6 is lost, the combination of the Y-capacitor arrangements 102,42 and the CP diode 41, means that there is still an AC connection between the PE and the vehicle's ground. The Y-capacitor arrangements 102,42 and the CP diode 41 therefore form a negative voltage charge pump circuit, with the voltage amplitude being dependent on the Y-capacitance and leakage from the Y-capacitor arrangements 102,42. As a result, when the CP signal applied by the charging station is in a -12V phase relative to the PE, the negative charge pump effect causes a voltage drop across the CP diode 41 of -15V to -24V relative to the vehicle ground. This contrasts with when the CP signal applied by the charging station is in a +12V phase relative to PE, in which the voltage across the CP diode 41 is 0V to 1V relative to the vehicle ground.

The first type of PE line fault may occur if the PE line 7 connection is lost between:
(i) the charging station 1 and its coupler 2,
(ii) the charging station 1 and the vehicle inlet 3, and there has been PP resistor damage 21,31, and
(iii) the vehicle inlet 3 and the vehicle charging controller 4, and there has been PP resistor damage 21,31.

It will be understood that the negative charge pump effect will occur when a fault is present while the vehicle is charging. Equally, testing may also be performed when the vehicle is not charging by triggering the charging station 1 to perform a testing mode in which a CP signal of +/-12V 1kHz at a minimum 3% duty cycle is applied to the CP line 5. In both scenarios, the diagnostic controller 10 may monitor the voltage at the voltage sensor 11, and if a negative amplitude greater than -15V is detected, it triggers a first fault indicator. In response, the vehicle charge controller 4 may stop charging and the fault may be logged in a fault log to direct repairs at a garage.

Figure 5 is a schematic illustration of a charging arrangement including a diagnostic apparatus according to a second embodiment. This embodiment is similar to the first embodiment, but further includes a current sensor 12 for sensing the Ipp current flowing through the pull up resistor on the PP line 6, with the diagnostic controller 10 monitoring this Ipp current.

In this respect, the pull up resistance and voltage on the PP line 6 is defined by the charging standard and, in the case of IEC 61851-1, is 330Ω and +5V regulated voltage, respectively. As mentioned above, the coupler 2 includes a 1.5kΩ coupler PP resistor 21, and the inlet 3 also includes a 4.7kΩ inlet PP resistor 31. The Ipp current is the sum of the currents flowing through the coupler PP resistor 21 and the inlet PP resistor 31.

In the event of a broken PE connection occurring at or after the coupler/inlet interface, where the PP resistors 21,31 remaining intact, they form a bypass connection bypassing broken PE line 7. As such, in this scenario, the 1kHz CP signal may be sensed on the PP line 6, with the amplitude of the current flow being indicative of where the fault has occurred.

In this connection, a fluctuating current is detected on the PP line 7 having a peak to trough amplitude from 1mA to 3mA, this is identified as relating to a second type of broken PE connection in which the PE line 7 is broken between the coupler 2 and a vehicle inlet 3, where the coupler PP resistor and inlet PP resistor are undamaged. However, if a fluctuating current is detected on the PP line 7 having an amplitude a peak to trough amplitude of 0mA to 2mA, this is identified as relating to a third broken PE connection fault in which the PE line is broken between a vehicle inlet and a vehicle charge controller, where a coupler PP resistor and inlet PP resistor are undamaged.

Again, it will be understood that the PP current effect can occur when the vehicle is charging. Equally, testing may also be performed when the vehicle is not charging by triggering the charging station 1 to perform a testing mode in which a CP signal of +/-12V 1kHz at a minimum 3% duty cycle is applied to the CP line 5. In both scenarios, the diagnostic controller 10 may monitor the voltage at the current sensor 12, and if current fluctuations are detected, it triggers a second or third fault indicator based on the amplitude of the detected signal. In response, the vehicle charge controller 4 may stop charging and the fault may be logged in a fault log to direct repairs at a garage.

Accordingly, embodiments provide a functional solution that will allow to diagnose faulty PE connections and differentiate between different types of faults to allow for simplified repair.

It will be understood that the embodiments illustrated above show applications only for the purposes of illustration. In practice, embodiments may be applied to many different configurations, the detailed embodiments being straightforward for those skilled in the art to implement.

For example, whilst the above embodiments are described in the context of a diagnostic apparatus integrated into a vehicle, it will be understood that charging stations may be tested using a separate diagnostic apparatus which includes a vehicle inlet 3 for receiving the coupler 2. In such an arrangement, the separate diagnostic apparatus may measure CP voltage and/or PP current in the same way.

Moreover, it will also be understood that a vehicle may be tested using test station device for simulating the role of the charging station. In such a case, the test station device may include a coupler which connects into the vehicle inlet for allowing the diagnostic apparatus to perform testing operations.

## Claims

1. A vehicle charging diagnostic apparatus comprising:
a voltage sensor for determining the voltage on a control pilot line; and
a diagnostic controller for identifying a first fault in response to detecting, using the voltage sensor, a negative voltage at or below a threshold.

2. A vehicle charging diagnostic apparatus according to claim 1, wherein the negative voltage corresponds to the charging station having a negative potential.

3. A vehicle charging diagnostic apparatus according to any preceding claim, wherein the diagnostic controller outputs a first fault indicator in response to identifying a first fault.

4. A vehicle charging diagnostic apparatus according to claim 3, wherein the first fault indicator is associated with a permanent earth disconnection fault between one of:
(i) a charging station and its coupler,
(ii) the charging station and a vehicle inlet, where an inlet proximity pilot (PP) resistor is damaged, and
(iii) the vehicle inlet and a vehicle charge controller, where an inlet PP resistor is damaged, and a coupler PP resistor is damaged.

5. A vehicle charging diagnostic apparatus according to any preceding claim, further comprising a current sensor for sensing the current on the proximity pilot (PP) line; and
wherein the diagnostic controller is further configured to monitor characteristics in the current sensed by the current sensor and identifying a further fault in response to detecting the detected characteristics.

6. A vehicle charging diagnostic apparatus according to claim 5, wherein the characteristics in the current comprise amplitude fluctuations.

7. A vehicle charging diagnostic apparatus according to claim 6, wherein the fluctuations in the current have a signal frequency of between 900Hz-1.1kHz.

8. A vehicle charging diagnostic apparatus according to any one of claims 6-7, wherein the diagnostic controller is configured to output a further fault indicator in response to identifying a further fault.

9. A vehicle charging diagnostic apparatus according to claim 8, wherein the diagnostic controller categorises the further fault based on a peak to trough amplitude being within a predetermined range.

10. A vehicle charging diagnostic apparatus according to any preceding claim, wherein the diagnostic controller is configured to stop a charging operation in response to identifying a first fault or a further fault.

11. A vehicle charging diagnostic apparatus according to claim 1, wherein the threshold is between -13 to -30V.

12. A vehicle charging diagnostic method comprising the steps of:
determining, using a voltage sensor, the voltage on a control pilot line; and
identifying, by a diagnostic controller, a first fault in response to detecting, using the voltage sensor, a negative voltage at or below a threshold.

13. A vehicle charging diagnostic method according to claim 12, further comprising the step of:
outputting, by the diagnostic controller, a first fault indicator in response to identifying a first fault.

14. A vehicle charging diagnostic method according to claim 12 or 13, further comprising the steps of:
sensing, using a current sensor, the current on the PP line; and
identifying, by the diagnostic controller, characteristics in the sensed current and identifying a further fault in response to the detected characteristics.

15. A non-transient computer readable medium comprising instructions which, when executed by a processor, implements the method according to any one of claims 12-14.
